(19)

**Europäisches Patentamt**
**European Patent Office**
**Office européen des brevets**

(11)  **EP 4 270 652 A1**

(12)  **EUROPEAN PATENT APPLICATION**
published in accordance with Art. 153(4) EPC

(43) Date of publication:
01.11.2023 Bulletin 2023/44

(21) Application number: 22876502.0

(22) Date of filing: 29.09.2022

(51) International Patent Classification (IPC):
*H01Q 15/02* (2006.01)    *G06F 30/10* (2020.01)
*G06F 30/23* (2020.01)

(52) Cooperative Patent Classification (CPC):
G06F 30/10; G06F 30/23; H01Q 15/02

(86) International application number:
PCT/JP2022/036578

(87) International publication number:
WO 2023/054639 (06.04.2023 Gazette 2023/14)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 30.09.2021 JP 2021161533

(71) Applicant: NITTO DENKO CORPORATION
Ibaraki-shi
Osaka 567-8680 (JP)

(72) Inventors:
• MATSUZAKI Yuya
Ibaraki-shi, Osaka 567-8680 (JP)
• FUKE Kazuhiro
Ibaraki-shi, Osaka 567-8680 (JP)
• SUZUKI Takuya
Ibaraki-shi, Osaka 567-8680 (JP)

(74) Representative: Grünecker Patent- und
Rechtsanwälte
PartG mbB
Leopoldstraße 4
80802 München (DE)

(54)  **METHOD FOR DESIGNING RADIO WAVE SCATTERING BODY, RADIO WAVE SCATTERING BODY DESIGNING DEVICE, AND PROGRAM FOR DESIGNING RADIO WAVE SCATTERING BODY**

(57)  A method for designing radio scattering bodies includes making a determination of a value Q1 of an objective function. The objective function represents a radio scattering property of a design target T for a case where a radio wave E is incident on the design target under a given condition. The determination of the value Q1 is made by computation using an analysis model M including the design target T, the analysis model being created on the basis of a set value P1 of a parameter describing a shape of the design target T.

FIG. 1

**Description**

TECHNICAL FIELD

The present invention relates to a method for designing radio scattering bodies, a radio scattering body design apparatus, and a program for designing radio scattering bodies.

BACKGROUND ART

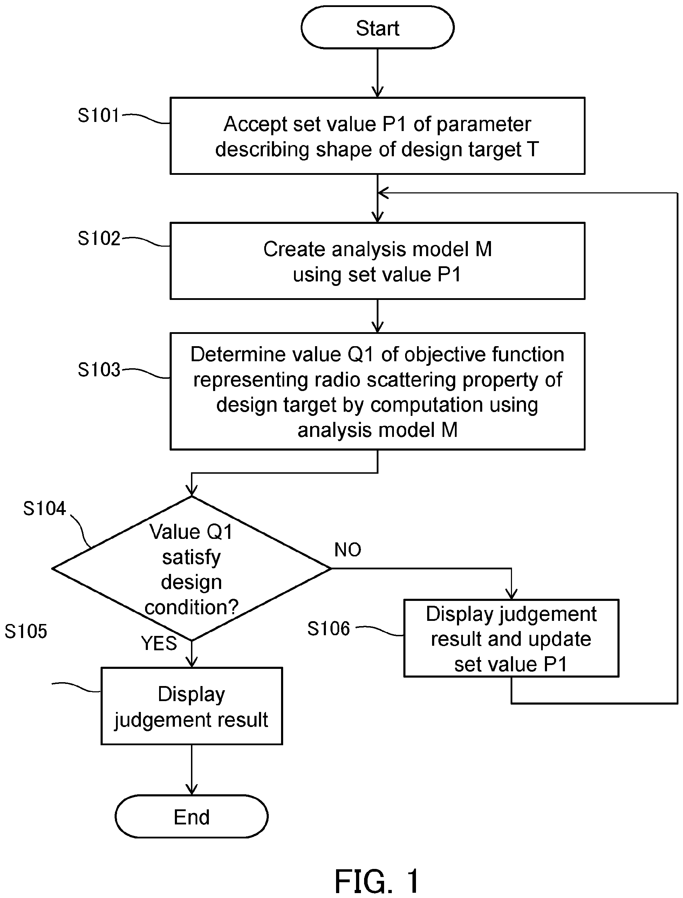

Components for adjusting travel of radio waves have been known.
Patent Literature 1 describes a side shield for radar transceivers. A non-uniform delay structure is arranged over the entire side shield.
Patent Literature 2 describes an electromagnetic wave absorber in which a plurality of scattering bodies each made of a second dielectric material and having a particular shape are cyclically arranged in a matrix made of a first dielectric material. The scattering bodies are arranged in the electromagnetic wave absorber, for example, such that flat matrix plates and flat scattering body plates are alternatively stacked (refer to FIG. 1(a)).

CITATION LIST

Patent Literature

Patent Literature 1: WO 2021/058450 A1
Patent Literature 2: JP 2004-153135 A

SUMMARY OF INVENTION

Technical Problem

Attenuating radio waves using a radio scattering body capable of transmitting and scattering radio waves is conceivable for prevention of reception of unnecessary radio waves. In designing a radio scattering body, a radio scattering property of a prototype can approach a desired scattering property through repetition of prototyping and evaluation. However, such a method requires a number of repetitions of prototyping and evaluation and can involve large amounts of labor and cost.
Therefore, the present invention provides a method for designing radio scattering bodies, the method having an advantage in cost effectiveness.

Solution to Problem

The present invention provides a method for designing radio scattering bodies, the method including making a determination, by means of an arithmetic logic unit, of a value of an objective function by computation using an analysis model including a design target, the analysis model being created on the basis of a set value of a parameter describing a shape of the design target, the objective function representing a radio scattering property of the design target for a case where a radio wave is incident on the design target under a given condition.
The present invention also provides a radio scattering body design apparatus including

an arithmetic logic unit, wherein
the arithmetic logic unit makes a determination of a value of an objective function by computation using an analysis model including a design target, the analysis model being created on the basis of a set value of a parameter describing a shape of the design target, the objective function representing a radio scattering property of the design target for a case where a radio wave is incident on the design target under a given condition.

The present invention also provides a program for designing radio scattering bodies, the program being for making a computer execute determination of a value of an objective function by computation using an analysis model including a design target, the analysis model being created on the basis of a set value of a parameter describing a shape of the design target, the objective function representing a radio scattering property of the design target for a case where a radio wave is incident on the design target under a given condition.

Advantageous Effects of Invention

The above method for designing radio scattering bodies has an advantage in cost effectiveness.

BRIEF DESCRIPTION OF DRAWINGS

FIG. 1 is a flow chart showing an example of the method for designing radio scattering bodies according to the present invention.
FIG. 2 is a block diagram showing a configuration of the design apparatus according to the present invention.
FIG. 3A is a plan view showing an example of a design target.
FIG. 3B is a cross-sectional view of the design target along a line B-B shown in FIG. 3A.
FIG. 4A is a perspective view schematically showing an analysis model.
FIG. 4B is a side view schematically showing an analysis model.
FIG. 4C is a side view schematically showing an analysis model.
FIG. 5 is a flow chart showing an example of a method for determining a response surface.
FIG. 6A is a graph showing an example of a response surface.
FIG. 6B is a graph showing an example of a response surface.
FIG. 6C is a graph showing an example of a response surface.
FIG. 6D is a graph showing an example of a response surface.
FIG. 6E is a graph showing an example of a response surface.
FIG. 6F is a graph showing an example of a response surface.
FIG. 6G is a graph showing an example of a response surface.
FIG. 6H is a graph showing an example of a response surface.
FIG. 6I is a graph showing an example of a response surface.
FIG. 6J is a graph showing an example of a response surface.
FIG. 6K is a graph showing an example of a response surface.

DESCRIPTION OF EMBODIMENTS

Hereinafter, embodiments of the present invention will be described with reference to the drawings. The present invention is not limited to the following embodiments.

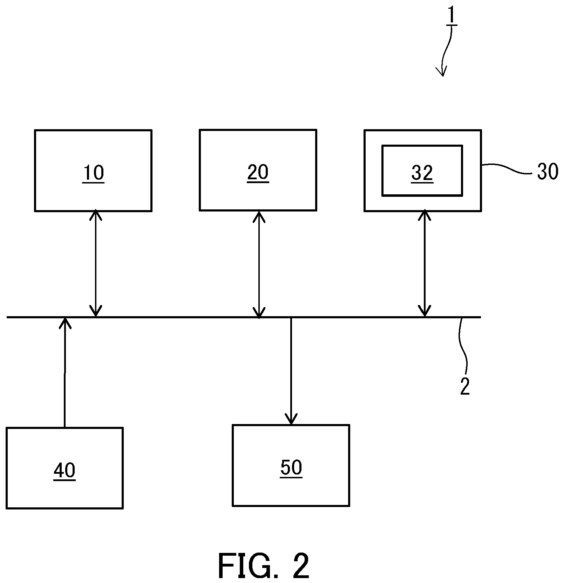

FIG. 1 is a flow chart showing an example of a method for designing radio scattering bodies. This design method is carried out, for example, using a design apparatus 1 shown in FIG. 2. The design apparatus 1 includes, for example, an arithmetic logic unit 10, a main storage unit 20, an auxiliary storage unit 30, an input interface 40, and a display unit 50. In the design apparatus 1, the arithmetic logic unit 10, the main storage unit 20, the auxiliary storage unit 30, the input interface 40, and the display unit 50 are each connected to a bus 2. For example, a central processing unit (CPU) is composed of the arithmetic logic unit 10 and a control unit (not illustrated). The main storage unit 20 is, for example, a semiconductor memory such as a RAM. The CPU may include the main storage unit 20. The arithmetic logic unit 10 carries out a calculation using date loaded into the main storage unit 20. The auxiliary storage unit 30 is, for example, a nonvolatile memory such as an HDD or a flash memory. A program 32 for designing radio scattering bodies is stored in the auxiliary storage unit 30. The program 32 is loaded into the main storage unit 20 and executed therein. For example, a result of calculation by the arithmetic logic unit 10 is stored in the auxiliary storage unit 30. The input interface 40 is, for example, an input device such as a keyboard, a mouse, or a touch panel.
As shown in FIG. 1, input of a set value P1 of a parameter describing a shape of a design target T is accepted in step S101. The set value P1 is input, for example, through the input interface 40 operated by a user. The set value P1 may be, for example, a value automatically generated on the basis of a CAD data. For example, the input interface 40 is operated by a user so as to load a given CAD data stored in the auxiliary storage unit 30, and consequently the set value P1 is determined.
Next, the procedure proceeds to step S102, in which an analysis model M is created using the set value P1. The analysis model M includes the design target T.
The analysis model M may be defined by a parameter other than the parameter describing the shape of the design target T. For example, the analysis model M may be created on the basis of a parameter describing a relative permittivity of the design target T. The parameter describing the relative permittivity of the design target T may have a constant value in the design target T, or may have a spatially variable value in the design target T.
The parameter describing the shape of the design target T is not limited to a particular parameter. The parameter describing the shape of the design target T includes, for example, a parameter describing a surface shape of the design target T. In this case, the analysis model M can be created taking the surface shape of the design target T into account.

The parameter describing the shape of the design target T includes, for example, a parameter describing a three-dimensional shape of a surface of the design target T. In this case, the analysis model M can be created taking the three-dimensional shape of the surface of the design target T into account.

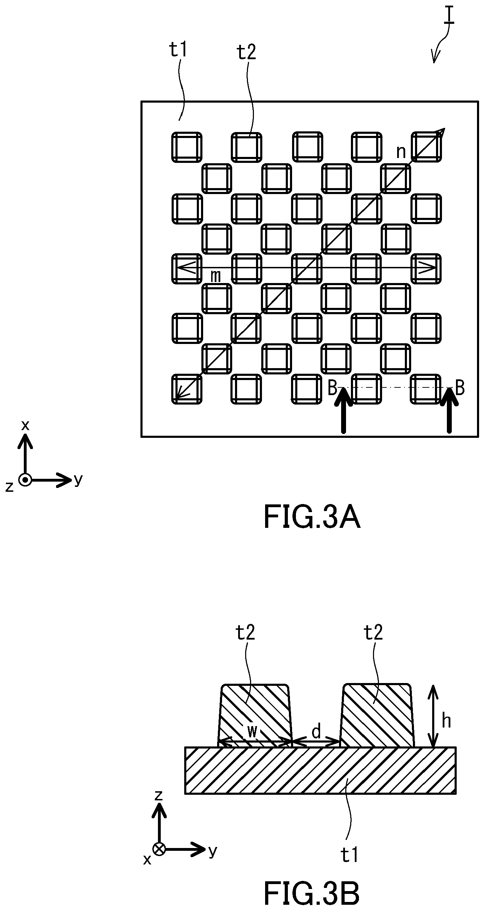

FIG. 3A and FIG. 3B show an example of the design target T. In this example, the design target T includes a base t1 in a flat plate shape and a plurality of projecting portions t2 arranged thereon. Each projecting portion t2 is, for example, in the shape of a truncated square pyramid. The plurality of projecting portions t2 are arranged to make a parallelogram lattice when the design target T is viewed in plan. For example, when the design target T is viewed in plan, side surfaces of the projecting portions t2 are aligned in a first direction m, and diagonal vertices of the projecting portions t2 are aligned in a second direction n crossing the first direction m. In this example, a width w of the projecting portion t2 in the first direction m, a distance d between the projecting portions t2 adjacent to each other in the first direction m, and a projection length h of the projecting portion t2 are each used as the parameter describing the surface shape of the design target T. For example, input of a value of the width w, a value of the distance d, and a set value of the projection length h is accepted in step S101. As described here, the set value P1 can include set values of a plurality of parameters. In FIG. 3A and FIG. 3B, the x axis, the y axis, and the z axis are orthogonal to each other.

The parameter describing the surface shape of the design target T is not limited to a particular parameter as long as the parameter describing the surface shape of the design target T describes the surface shape of the design target T. For example, a value of the parameter describing the surface shape of the design target T may be a value specifying the shape of the projecting portion t2, or may be a value specifying arrangement of the plurality of projecting portions t2.

A parameter for defining the design target T may include a parameter other than the parameter describing the surface shape of the design target T. For example, the parameter for defining the design target T may include the parameter describing the relative permittivity of the design target T. The parameter describing the relative permittivity of the design target T may have a constant value in the design target T, or may have a spatially variable value in the design target T.

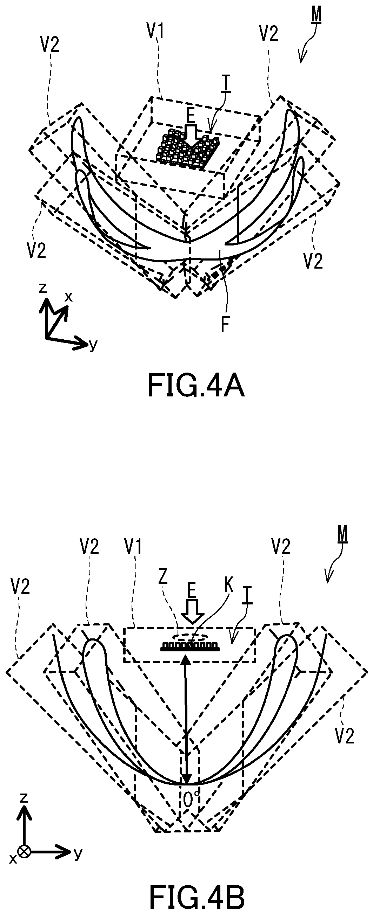

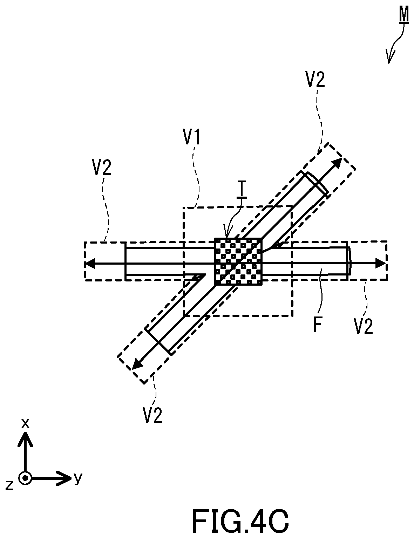

FIG. 4A, FIG. 4B, and FIG. 4C show an example of the analysis model M. The analysis model M includes, for example, information related to a condition for a radio wave E to be incident on the design target T. The information includes information, for example, related to a frequency of the radio wave E, a direction of an electric field of the radio wave E, a direction where the radio wave E is incident on the design target T, and a radio wave incident range Z of the design target T. In FIG. 4A, FIG. 4B, and FIG. 4C, the x axis, the y axis, and the z axis are orthogonal to each other. The frequency of the radio wave E is not limited to a particular value. The frequency of the radio wave E is set, for example, in the range of 10 to 300 GHz.

A computation space V1 and a computation space V2 are defined in the analysis model M. The computation space V1 is a space containing the design target T. The computation space V2 is a space being distant from the design target T and containing a receiving plane F on which an intensity of the radio wave E having passed through the design target T is to be evaluated. The receiving plane F is defined on a hemispherical surface having its center at a particular point K on the design target T. Additionally, the receiving plane F is defined to have given dimensions along the first direction m and the second direction n when the design target T in the analysis model M is viewed in plane. The particular point K is a point, for example, where a surface of the design target T from which a radio wave emerges and a straight line extending in a straight direction of the radio wave E intersect.

The procedure proceeds to step S103, in which a determination of a value Q1 of an objective function representing a radio scattering property of the design target T for a case where the radio wave E is incident on the design target T under the given condition is made by computation using the analysis model M. The determination of the value Q1 is made by means of the arithmetic logic unit 10. In the computation using the analysis model M, for example, radio wave intensities in the computation space V1 and the computation space V2 can be obtained by numerically solving Maxwell's equations. For example, the radio wave intensities in the computation space V1 and the computation space V2 are computed according to the finite element method and the method of moments. The method of moments is applied, for example, to a boundary of a region to which the finite element method is applied. The finite element method may be applied to computation for the design target T and computation for the receiving plane F, and the method of moments may be applied to computation for a region other than the design target T and the receiving plane F. As a result, a computation cost for computation using the analysis model M is likely to be decreased and a computation time is likely to be shortened.

The objective function whose value Q1 is obtained in step S103 is not limited to a particular function as long as the objective function represents the radio scattering property of the design target T. The value Q1 is, for example, determined on the basis of a computed value of a transmission loss for a case where the radio wave E is incident on the design target T under the given condition. For example, the value Q1 is determined as the minimum transmission loss at the receiving plane F.

The transmission loss is expressed, for example, by the following equation (1). In the equation (1), $T_i$ [W] is a

computed value of a radio wave intensity at the receiving plane F, the computed value being based on the above computation using the analysis model M. The symbol $T_N$ [W] is a reference radio wave intensity in free space. The symbol $T_N$ is, for example, a radio wave intensity at a position where the radio wave E going straight and the receiving plane F intersect, the radio wave intensity being measured when the radio wave E travels in the analysis model M without the design target T.

$$\text{Transmission loss [dB]} = -10\log_{10}(T_i/T_N) \qquad \text{Equation (1)}$$

For example, the incident condition for the radio wave E is established so that the radio wave E is perpendicularly incident in a 30 mm-diameter range of a region corresponding to the particular point K of the design target T. Additionally, the receiving plane F is defined as a track made by a circle having a diameter of 30 mm and moving along a given longitude line of a hemisphere having a radius of 120 mm and its center at the particular point K. In this case, the design target T can be considered to be a radio scattering body if, for example, the transmission loss is 4 dB or more at an intersection of the straight line extending from the particular point K in the straight direction of the radio wave E and the receiving plane F.

The radio scattering body may be, for example, capable of transmitting a radio wave and scattering the transmitted radio wave. Such a radio scattering body may have, for example, a surface which has projections and recesses and on which a radio wave is to be incident.

Next, the procedure proceeds to step S104, in which a judgement on whether the value Q1 satisfies a predetermined design condition related to the radio scattering property of the design target T is made. This judgement is made by means of the arithmetic logic unit 10. Step S104 may be omitted in some cases. In such cases, for example, the value Q1 is displayed on the display unit 50.

When the judgement result in step S104 is positive, the procedure proceeds to step S105, in which the positive judgement result is displayed on the display unit 50 and the series of processes ends. The value Q1 may be displayed on the display unit 50 in step S105.

When the judgement result in step S104 is negative, the procedure proceeds to step S106, in which the negative judgement result is displayed on the display unit 50 and an update of the set value P1 is made. The value Q1 may be displayed on the display unit 50 in step S106. The method for updating the set value P1 is not limited to a particular method. The set value P1 is updated, for example, according to an optimization algorithm such as a gradient method or a genetic algorithm. Subsequently, the procedure goes back to step S102. The processes of step S102 and step S103 are performed using the updated set value P1, and then the judgement of step S104 is made.

As shown in FIG. 1, the update of the set value P1, the determination of the value Q1, and the judgement on whether the value Q1 satisfies the design condition are repeated until the value Q1 of the objective function is judged to satisfy the design condition.

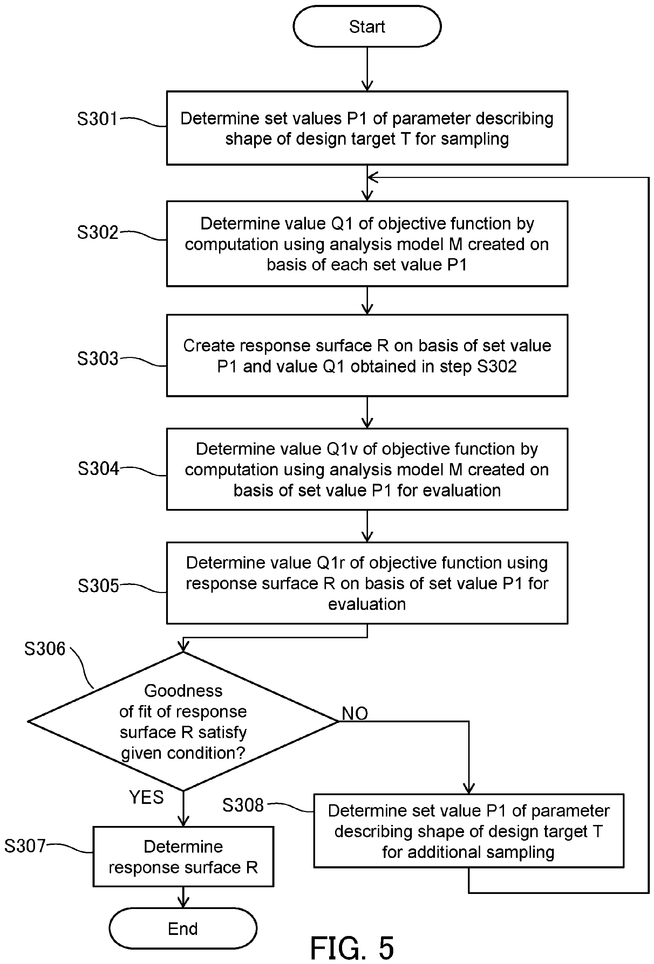

A response surface R in which the parameter describing the shape of the design target T is a design variable may be used for the determination of the value Q1 of the objective function in step S103. FIG. 5 shows an example of the method for determining the response surface R. This method is performed using the design apparatus 1.

In step S301, set values P1 of the parameter describing the shape of the design target T for sampling are determined. Each set value P1 for sampling can include set values of a plurality of parameters. For example, the number of set values P1 for sampling is 20 or more.

The method for determining the set values P1 for sampling is not limited to a particular method. For example, the set values P1 for sampling can be determined according to the design of experiments such as central composite design (Box-Wilson design).

Next, the procedure proceeds to step S302. As in step S102 and step S103, an analysis model M is created on the basis of each set value P1, and a value Q1 of the objective function is determined by computation using each analysis model M, the value Q1 corresponding to each set value P1.

Next, the procedure proceeds to step S303. On the basis of the set values P1, determined in step S301, of the parameter and the values Q1, determined in step 302, of the objective function, a response surface R in which the parameter is a design variable is created. The method for creating the response surface R is not limited to a particular method. The response surface R can be created, for example, using a metamodeling algorithm such as hereditary set.

Next, a set value P1 of the parameter describing the shape of the design target T for evaluation is determined. As in step S102 and step S103, a value Q1v of the objective function is determined in step S304 by computation using an analysis model M created on the basis of the set value P1 for evaluation, the value Q1v corresponding to the set value P1 for evaluation. Additionally, a value Q1r of the objective function is determined in step S305 using the response surface R created in step S303, the value Q1r corresponding to the set value P1 for evaluation. The processes of step S304 and step S305 may be sequentially executed, or may be executed in parallel.

Next, the procedure proceeds to step S306, and whether the goodness of fit of the response surface R created in step S303 satisfies a given condition is judged. This judgement depends, for example, on whether a difference between the value Q1v and the value Q1r is in an acceptable range. For example, in the case where the value Q1r has an error of 15% or less from the value Q1v, the goodness of fit of the response surface R is judged to satisfy the given condition.

When the judgement in step S306 is positive, the procedure proceeds to step S307, and the response surface R created in step S303 is determined as a response surface in which the parameter describing the shape of the design target T is a design variable. Data of this response surface R is stored in the auxiliary storage unit 30. In step S103, the value Q1 of the objective function can be determined using the response surface R stored in the auxiliary storage unit 30.

When the judgement in step S306 is negative, the set value P1 of the parameter describing the shape of the design target T for additional sampling is determined. For example, a value close to a set value of the parameter is selected as the set value P1 for additional sampling, the set value corresponding to the value Q1r having a relatively large error from the value Q1v in the response surface R. After that, the procedure goes back to the process of step S302, and the processes of step S302 to step S306 are executed again using the set value P1 for additional sampling. In this manner, a response surface R providing the value Q1 of the objective function with high prediction accuracy can be determined. An approximate value of an optimal solution of the parameter describing the shape of the design target T can be determined using such a response surface R.

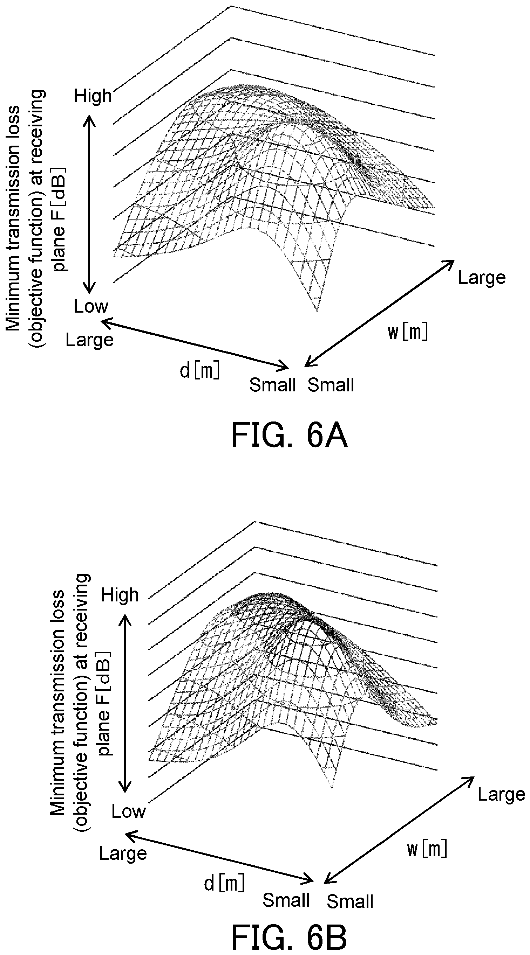

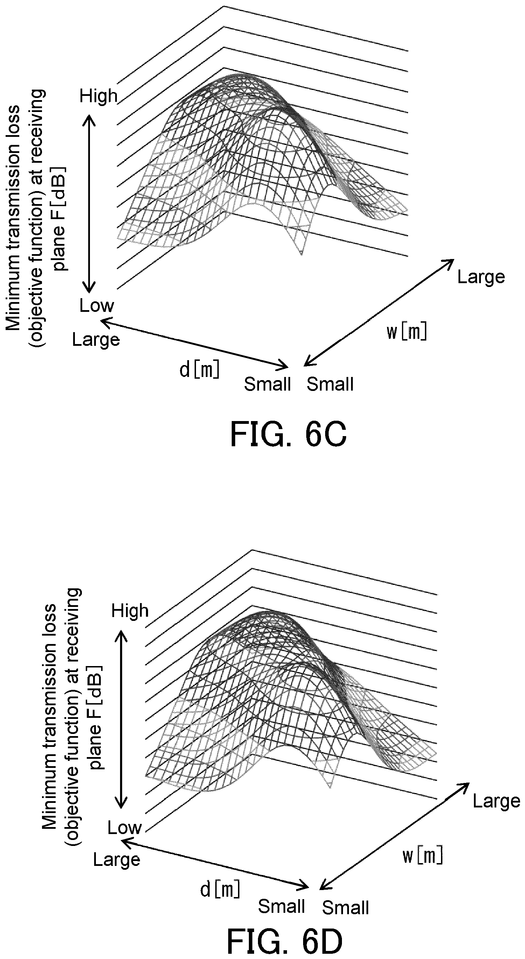

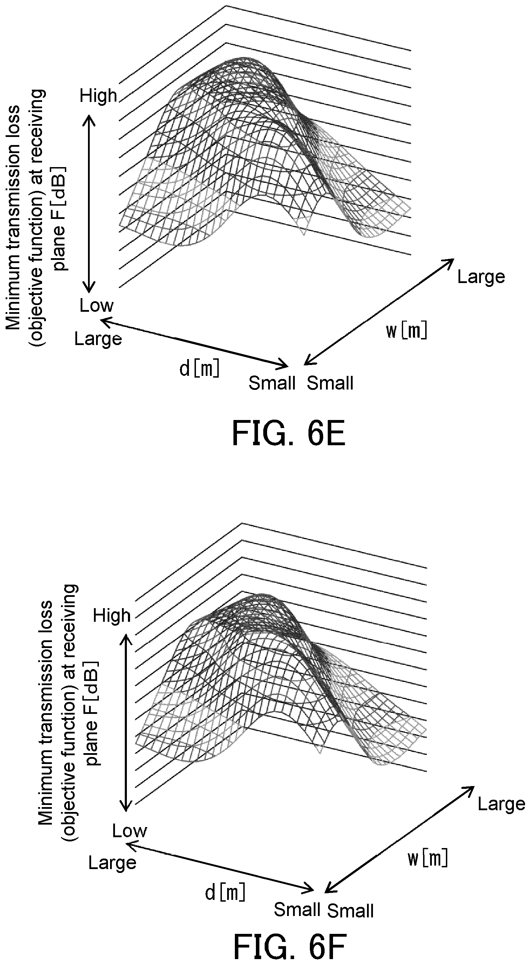

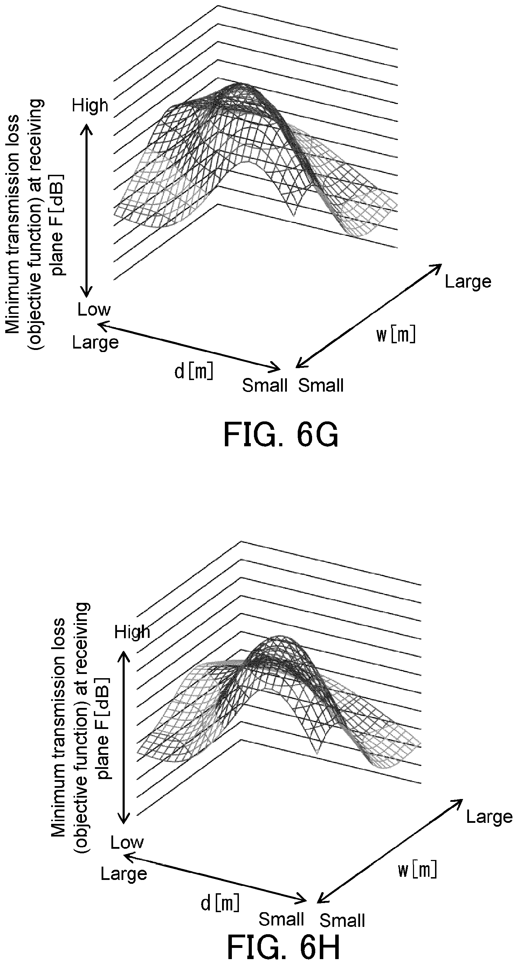

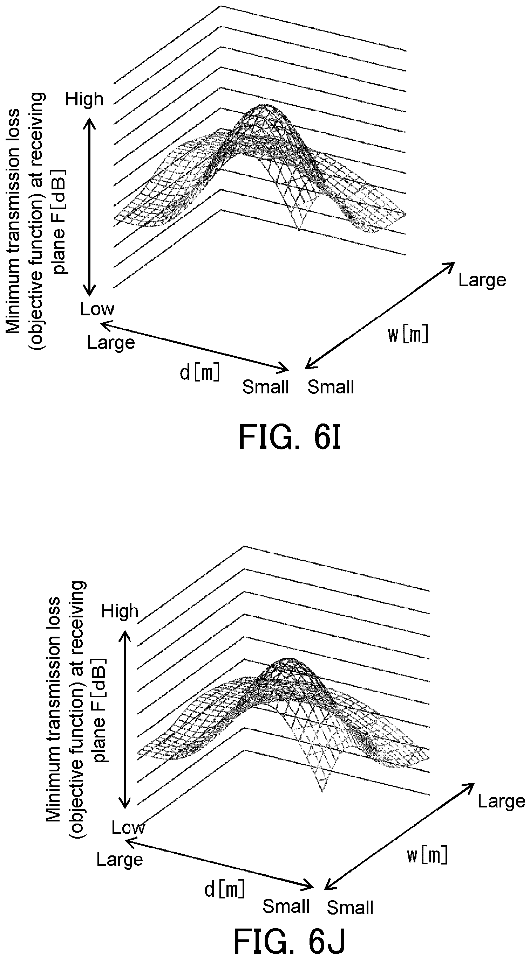

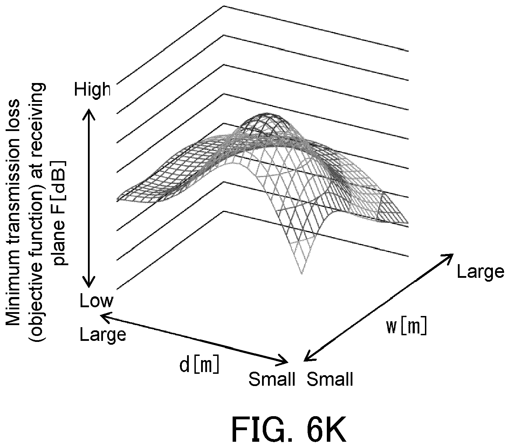

FIG. 6A to FIG. 6K show response surfaces R in which the width w [m], the distance d [m], and the projection length h [m] of the design target T as shown in FIG. 3A and FIG. 3B are design variables. The projection length h is constant in each of the response surfaces R shown in FIG. 6A to FIG. 6K. The projection length h increases by a constant increment from FIG. 6A to FIG. 6K.

The design apparatus 1 can be modified in various respects. For example, the design apparatus 1 may be configured such that the program 32 is stored in an executable manner in a server connected to a network such as the Internet. In this case, for example, the server retrieves, through the network, the set value P1 input from a client connected to the network. In addition, the server sends the information of the judgement result in step S104 to the client, and a display unit of the client receiving the information displays the judgement result. Alternatively, the display unit of the client displays the value Q1, determined in step S103, of the objective function.

**Claims**

1. A method for designing radio scattering bodies, the method comprising
   making a determination, by means of an arithmetic logic unit, of a value of an objective function by computation using an analysis model including a design target, the analysis model being created on the basis of a set value of a parameter describing a shape of the design target, the objective function representing a radio scattering property of the design target for a case where a radio wave is incident on the design target under a given condition.

2. The method according to claim 1, further comprising
   making a judgment, by means of an arithmetic logic unit, on whether the value of the objective function satisfies a predetermined design condition related to the radio scattering property of the design target.

3. The method according to claim 1 or 2, wherein the parameter includes a parameter describing a surface shape of the design target.

4. The method according to any one of claims 1 to 3, wherein the parameter includes a parameter describing a three-dimensional shape of a surface of the design target.

5. The method according to any one of claims 1 to 4, wherein the value of the objective function is determined on the basis of a computed value of a transmission loss for a case where the radio wave is incident on the design target under the given condition.

6. The method according to any one of claims 1 to 5, wherein the analysis model is created on the basis of a parameter describing a relative permittivity of the design target.

7. The method according to any one of claims 1 to 6, wherein the determination of the value is made using a response surface in which a parameter describing a surface shape of the design target is a design variable.

8. The method according to any one of claims 1 to 7, further comprising:

   making a judgement, by means of an arithmetic logic unit, on whether the value of the objective function satisfies a predetermined design condition related to the radio scattering property of the design target; and displaying a result of the judgement.

9. The method according to any one of claims 1 to 8, further comprising

making a judgement, by means of an arithmetic logic unit, on whether the value of the objective function satisfies a predetermined design condition related to the radio scattering property of the design target, wherein when the value of the objective function is judged not to satisfy the design condition, an update of the value of the parameter is made and the determination and the judgement are made on the basis of a value of the parameter after the update.

10. The method according to claim 9, wherein the update, the determination, and the judgement are repeated until the value of the objective function is judged to satisfy the design condition.

11. A radio scattering body design apparatus comprising

an arithmetic logic unit, wherein
the arithmetic logic unit makes a determination of a value of an objective function by computation using an analysis model including a design target, the analysis model being created on the basis of a set value of a parameter describing a shape of the design target, the objective function representing a radio scattering property of the design target for a case where a radio wave is incident on the design target under a given condition.

12. The design apparatus according to claim 11, wherein the arithmetic logic unit makes a judgement on whether the value of the objective function satisfies a predetermined design condition related to the radio scattering property of the design target.

13. The design apparatus according to claim 11 or 12, wherein the parameter includes a parameter describing a surface shape of the design target.

14. The design apparatus according to claim 11 or 12, wherein the parameter includes a parameter describing a three-dimensional shape of a surface of the design target.

15. The design apparatus according to any one of claims 11 to 14, wherein the value of the objective function is determined on the basis of a computed value of a transmission loss for a case where the radio wave is incident on the design target under the given condition.

16. The design apparatus according to any one of claims 11 to 15, wherein the analysis model is created on the basis of a parameter describing a relative permittivity of the design target.

17. The design apparatus according to any one of claims 11 to 16, wherein the determination of the value is made using a response surface in which a parameter describing a surface shape of the design target is a design variable.

18. The design apparatus according to any one of claims 11 to 17, wherein

the arithmetic logic unit makes a judgement on whether the value of the objective function satisfies a predetermined design condition related to the radio scattering property of the design target; and
the arithmetic logic unit displays a result of the judgement.

19. The design apparatus according to any one of claims 11 to 18, wherein

the arithmetic logic unit makes a judgement on whether the value of the objective function satisfies a predetermined design condition related to the radio scattering property of the design target, wherein
when the value of the objective function is judged not to satisfy the design condition, the arithmetic logic unit makes an update of the value of the parameter and makes the determination and the judgement on the basis of a value of the parameter after the update.

20. The design apparatus according to claim 19, wherein the arithmetic logic unit repeats the update, the determination, and the judgement until the value of the objective function is judged to satisfy the design condition.

21. A program for designing radio scattering bodies, the program being for making a computer execute determination of a value of an objective function by computation using an analysis model including a design target, the analysis model being created on the basis of a set value of a parameter describing a shape of the design target, the objective function representing a radio scattering property of the design target for a case where a radio wave is incident on the design target under a given condition.

Start

S101 — Accept set value P1 of parameter describing shape of design target T

S102 — Create analysis model M using set value P1

S103 — Determine value Q1 of objective function representing radio scattering property of design target by computation using analysis model M

S104 — Value Q1 satisfy design condition?

NO

YES

S105 — Display judgement result

S106 — Display judgement result and update set value P1

End

FIG. 1

1

10

20

32    30

2

40

50

FIG. 2

FIG.3A

FIG.3B

FIG.4A

FIG.4B

FIG.4C

Start

S301 — Determine set values P1 of parameter describing shape of design target T for sampling

S302 — Determine value Q1 of objective function by computation using analysis model M created on basis of each set value P1

S303 — Create response surface R on basis of set value P1 and value Q1 obtained in step S302

S304 — Determine value Q1v of objective function by computation using analysis model M created on basis of set value P1 for evaluation

S305 — Determine value Q1r of objective function using response surface R on basis of set value P1 for evaluation

S306 — Goodness of fit of response surface R satisfy given condition?

NO

YES

S308 — Determine set value P1 of parameter describing shape of design target T for additional sampling

S307 — Determine response surface R

End

FIG. 5

FIG. 6A

FIG. 6B

FIG. 6C

FIG. 6D

FIG. 6E

FIG. 6F

FIG. 6G

FIG. 6H

FIG. 6I

FIG. 6J

FIG. 6K

## INTERNATIONAL SEARCH REPORT

| International application No. |
|---|
| **PCT/JP2022/036578** |

### A. CLASSIFICATION OF SUBJECT MATTER

*H01Q 15/02*(2006.01)i; *G06F 30/10*(2020.01)i; *G06F 30/23*(2020.01)i
FI:   G06F30/23; H01Q15/02; G06F30/10 100

According to International Patent Classification (IPC) or to both national classification and IPC

### B. FIELDS SEARCHED

Minimum documentation searched (classification system followed by classification symbols)

H01Q15/02; G06F30/10; G06F30/23

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2019-96240 A (SUBARU CORP.) 20 June 2019 (2019-06-20)<br>    paragraphs [0014]-[0048] | 1-21 |
| A | JP 2019-128918 A (NIHON UNIV.) 01 August 2019 (2019-08-01)<br>    paragraphs [0016], [0017] | 1-21 |
| A | JP 2016-71646 A (FUJI HEAVY IND. LTD.) 09 May 2016 (2016-05-09)<br>    paragraphs [0042]-[0044] | 1-21 |
| A | MICHAELI, Arie. Elimination of infinities in equivalent edge currents, part 1: Fringe current components. IEEE Transactions on Antennas and Propagation. vol. AP-34, no. 7, July 1986, 31 July 1986, pp. 912-918<br>    entire text, all drawings | 1-21 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **28 October 2022** | **08 November 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/036578**

| Patent document cited in search report | | | Publication date (day/month/year) | Patent family member(s) | Publication date (day/month/year) |
|---|---|---|---|---|---|
| JP | 2019-96240 | A | 20 June 2019 | (Family: none) | |
| JP | 2019-128918 | A | 01 August 2019 | (Family: none) | |
| JP | 2016-71646 | A | 09 May 2016 | US 2016/0092629 A1 paragraphs [0078]-[0086] | |

Form PCT/ISA/210 (patent family annex) (January 2015)

**EP 4 270 652 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2021058450 A1

- JP 2004153135 A